# EUROPEAN PATENT SPECIFICATION

(11) **EP 4 631 162 B1**
(45) Date of publication and mention of the grant of the patent: **01.07.2026**
(21) Application number: 23820994.4
(22) Date of filing: 05.12.2023
(51) Int. Cl.: H02N 2/18, F42C 11/00, F42C 11/02, H10N 30/30, H02N 2/04

(54) **ENERGY HARVESTING SYSTEM**
ENERGIEGEWINNUNGSSYSTEM
SYSTÈME DE COLLECTE D'ÉNERGIE

(30) Priority: 05.12.2022 GB 202218238; 05.12.2022 EP 22275153
(43) Date of publication of application: 15.10.2025
(73) Proprietor: BAE SYSTEMS plc, London SW1Y 5AD (GB)
(72) Inventor: HUCKER, Martyn John, Glascoed, Monmouthshire NP15 1XL (GB); CRAWLEY, Fergus Julian Edward, Cranfiled, Bedfordshire MK 43 0AL (GB)
(74) Representative: BAE SYSTEMS plc Group IP Department
(86) International application number: PCT/GB2023/053129
(87) International publication number: WO 2024/121542

(56) References cited:
- CN-A- 108 493 328
- US-A1- 2008 129 151
- QIAO Y ET AL: "Design and Fabrication of an Underwater Transducer Based on the Shear Vibration Mode and Trapezoid Transition Layer", MICROMACHINES, vol. 13, no. 8, 15 August 2022 (2022-08-15), XP093044733, DOI: 10.3390/mi13081320
- GAO X ET AL: "High output power density of a shear-mode piezoelectric energy harvester based on Pb(In1/2Nb1/2)O3-Pb(Mg1/3Nb2/3)O3-PbTiO3 single crystals", APPLIED ENERGY, ELSEVIER SCIENCE PUBLISHERS, GB, vol. 271, 28 May 2020 (2020-05-28), XP086175812, ISSN: 0306-2619, [retrieved on 20200528], DOI: 10.1016/J.APENERGY.2020.115193
- ERHART J ET AL: "Piezoelectric composite "shear-moonie" transducer", ANNALES DE CHIMIE SCIENCE DES MATÉRIAUX, vol. 26, no. 1, 1 January 2001 (2001-01-01), Cachan, pages 173 - 176, XP093044739, Retrieved from the Internet <URL:https://www.sciencedirect.com/science/article/pii/S0151910701900327/pdf?md5=426188b17eea66d2740f20ebbc6e7aea&pid=1-s2.0-S0151910701900327-main.pdf> DOI: 10.1016/S0151-9107(01)90032-7

## Description

### Field

The invention relates to an energy harvesting system comprising a transducer and a structure in mechanical communication with the transducer.

### Background to the Invention

Energy harvesting refers to the derivation of energy from external sources. For example, energy harvesting may mean deriving an electrical output from a mechanical input. A transducer is a device that is often used in energy harvesting systems, because it is able to convert energy from one form to another (transduction). Clearly, it is desirable to generate as much energy as possible from a given input, to increase power generation or detection sensitivities. Hence, there is a need for an energy harvesting system that facilitates efficient energy harvesting.

CN 108 493 328 B relates to a piezoelectric vibrator, a flextensional transducer and a manufacturing method thereof based on shear vibration and flextensional vibration.

QIAO Y ET AL, Design and Fabrication of an Underwater Transducer Based on the Shear Vibration Mode and Trapezoid Transition Layer, MICROMACHINES, vol. 13, no. 8, 1320, 15 August 2022, describes an underwater transducer developed using the d15 shear vibration mode of piezoelectric ceramic and a trapezoid transition layer.

US 2008/129151 A relates to piezoelectric generators for munitions fuzing.

### Summary of the Invention

It is one aim of the present invention, amongst others, to provide an energy harvesting system which at least partially obviates or mitigates at least some of the disadvantages of the prior art, whether identified herein or elsewhere, or to provide an alternative approach. For instance, it is an aim of embodiments of the invention to provide an energy harvesting system that facilitates efficient energy harvesting.

According to a first aspect, there is provided an energy harvesting system, comprising a transducer and a structure. The transducer is arranged to provide an output signal in response to deformation of the transducer by an applied force to harvest energy from the applied force. The structure is in mechanical communication with the transducer and extends across the transducer, deformation of the structure being arranged to cause deformation of the transducer. The mechanical communication is at a number of distinct points. Portions of the structure are angled away from being perpendicular to the transducer, whereby a compressive force applied to the structure and transducer is redirected to a shear force on the transducer at the points.

Portions of the structure which are at adjacent points may be angled away from each other.

The shear force may be directed toward/away from adjacent points.

Adjacent points may be equally distributed.

The structure may have a wave-like profile.

A perimeter of the structure and/or transducer is circular.

The structure and/or transducer may have an annular cross-section.

The structure is configured to redirect the shear force in circumferential direction.

The transducer may be piezoelectric or magnetostrictive.

The transducer may be more efficient under shear force than under compression in terms of providing an output signal in response to deformation of the transducer by an applied force.

The system may further comprise an electrode arrangement. The configuration of the electrode arrangement may be arranged to map onto the points.

The output signal may be used for powering an external component and/or detecting a change in state in the energy harvesting system.

According to a second aspect that is not part of the present invention, there is provided a structure for use in an energy harvesting system, the energy harvesting system comprising a transducer arranged to provide an output signal in response to deformation of the transducer by an applied force to harvest energy from the applied force, the structure being in mechanical communication with the transducer and extending across the transducer, deformation of the structure being arranged to cause deformation of the transducer, wherein the mechanical communication is at a number of distinct points, and wherein portions of the structure are angled away from being perpendicular to the transducer, whereby a compressive force applied to the structure and transducer is redirected to a shear force on the transducer at the points.

According to a third aspect, there is provided a projectile comprising the system of the first aspect.

According to a fourth aspect, there is provided a munition comprising the system of the first aspect.

### Brief Description of the Drawings

For a better understanding of the invention, and to show how exemplary embodiments of the same may be brought into effect, reference will be made, by way of example only, to the accompanying diagrammatic Figures, in which:
Figure 1 schematically depicts a transducer according to an exemplary embodiment;
Figure 2 schematically depicts a structure for mechanical communication with the transducer according to an exemplary embodiment;
Figure 3 schematically depicts a side perspective of the structure of Figure 2 according to an exemplary embodiment; and
Figure 4 schematically depicts a projectile or munition comprising a system including the transducer of Figure 1 and the structure of Figures 2 and 3 or the structure of Figures 2 and 3 according to an exemplary embodiment.

### Detailed Description

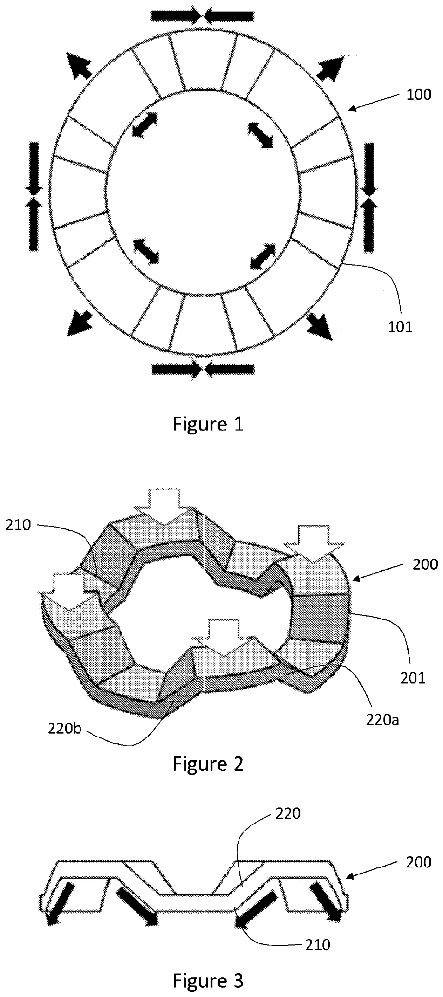

The energy harvesting system comprises a transducer and a structure. The transducer 100 is shown in Figure 1 and the structure 200 is shown in Figures 2 and 3. The transducer 100 and the structure 200 are shown separately in Figures 1 to 3, but, as explained below, as part of the energy harvesting system they are typically in physical contact. The structure 200 could be integrated in the energy harvesting system or could be a separate part of the energy harvesting system that can be exchanged and replaced.

The transducer 100 is arranged to provide an output signal. The output signal is outputted in response to deformation of the transducer 100 by an applied force resulting from a compressive force (indicated by the thick arrows in Figure 2) applied to the structure 200 and transducer 100. The transducer 100 typically comprises piezoelectric material, preferably perovskite, or a magnetostrictive material. Advantageously, these materials allow generation of energy in response to an applied force. Piezoelectric materials may be preferred, since they generate power without the need for, e.g. a take-off coil arrangement or similar. Perovskite materials or structures may find particular use in the embodiments discussed here, due to the fact that such materials may be more efficient at energy generation under shear force, compared with compressive force.

The structure 200, shown separately from the transducer 100 in Figures 2 and 3 for clarity, is in mechanical communication with the transducer 100 and extends across the transducer 100. Being in mechanical communication typically means that the structure 200 contacts the transducer 100. For example, the structure 200 may overlay the transducer 100. This contact may be mediated by a material in between the transducer 100 and the structure 200. As a consequence of the mechanical communication between the structure 200 and the transducer 100, deformation of the structure 200 causes deformation of the transducer 100.

The mechanical communication is at a number of distinct points 210. In other words, the mechanical communication between the transducer 100 and the structure 200 is at points 210 that are spaced apart. For example, the transducer 100 and the structure 200 may be in contact only at intervals.

The structure 200 comprises portions 220. As shown in Figures 2 and 3, the portions 220 of the structure 200 are each angled away from being perpendicular to the transducer 100. In other words, the angle between each of the portions 220 and the transducer 100 deviates from 90 degrees. For example, when the structure 200 is overlaid on the transducer 100 (so that the perimeter 201 of the structure 200 tracks the perimeter 101 of the transducer 100), each of the portions 220 is at an angle of between 0 degree and 90 degrees with respect to the transducer 100. As a result of the angled arrangement of the portions 220, the compressive force (indicated by the thick arrows in Figure 2) applied to the structure 200 and transducer 100 is redirected to a shear force (see thick arrows in Figure 3) on the transducer 100 at the points 210. To this end, the transducer 100 may be more efficient under shear force than under compression in terms of providing an output signal in response to deformation of the transducer 100 by the applied force. Or, the embodiment might simply provide an alternative to the use of compression, which might be useful. For example, conversion or direction to a shear force, at multiples points, might result in an alternative or improved conversion of mechanical input to energy generation.

In order to enhance the shear force on the transducer 100, the portions 220 of the structure 100 which are at adjacent points may be angled away from each other. In other words, the portions 220 of the structure 220 which are at adjacent points may fan out towards the transducer 100. In this way, a pinch/pull effect on the transducer 100 is generated. Similarly, and for the same reasons, the shear force may be directed toward/away from adjacent points. Portions 220 of the structure which are at adjacent points typically means a set of pairs of the portions 220. For instance, in Figure 2 portions 220a and 220b are a pair of portions 220 at adjacent points.

There will likely be radial spreading of the transducer 100 as result of the applied forces, shown by thick radial arrows in the Figure. An annular structure, as shown, might be better at accommodating such spread, compared with a disc or circle structure. For example, having an inner hole or space might prevent the introduction of odd or unexpected forces, or buckling, at the central region of the transducer. This is also discussed below.

Adjacent points may be equally distributed. For example, the adjacent points may be separated by equal (i.e., regular) intervals. Advantageously, this arrangement of the adjacent points 210 results in the shear force on the transducer 100 being uniformly distributed. Similarly, uniform distribution of the shear force on the transducer 100 may be facilitated by the structure 200 having a wave-like profile. A wave-like profile is also advantageous as it is easy to manufacture.

The perimeter 201 of the structure 200 and/or the perimeter 101 of the transducer 100 is circular (i.e., the structure 200 and/or the transducer 100 may be disc shaped), as shown in Figures 1 to 3. In other words, the outline of the structure 200 and/or transducer 100 is circular. Advantageously, the absence of corners engenders predictability of the direction of the shear force. A cross-section of the structure 200 and/or transducer 100 may be annular. In other words, the structure 200 and/or transducer 100 may have a circular outline with a cavity (e.g., a cylindrical cavity) along its or their central axis. Advantageously, in addition the absence of corners engendering predictability of the direction of the shear force, an annular cross-section facilitates flexibility of the structure 200 and/or transducer 100 and enables the structure 200 and/or transducer 100 to uniformly expand under compressive force, which may help avoid damage.

The structure 200 is configured to redirect the shear force in circumferential direction. Advantageously, redirecting the shear force in circumferential direction means that the shear force can be applied non-linearly to the transducer 100, thereby increasing the number of pinch/pull points and hence maximising the energy harvested. A circumferential direction means a direction has a non-radial component (e.g., a tangential component).

The output signal may be used for powering an external component. Instead or additionally, the output signal may be used for detecting a change in state in the energy harvesting system. Consequently, the energy harvesting system may be used for power generation or as a sensor. Power generation may be more efficient. Similarly, the sensor may be more sensitive.

Although not shown in the Figures, the system will typically comprise an electrode arrangement, for use in taking power from the transducer. This could be part of the transducer, or connected to the transducer. As discussed above, the use of distinct contact points is advantageous. The configuration of the electrode arrangement may be arranged to map onto the points. This might mean that the electrode arrangement is shaped or formed, or has one or more electrodes, that are linked to the location, shape, or area of the distinct points. For example, having one or more electrodes or electrode regions in the vicinity of the distinct points (e.g. where the shear forces are introduced) might allow for more efficient or effective energy harvesting at (e.g. taking power from) those points, or areas near those points, or between adjacent points.

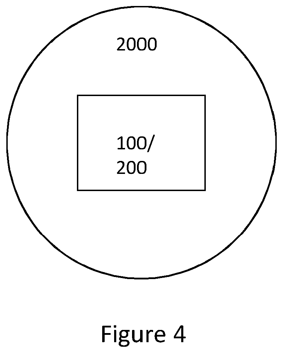

Figure 4 schematically depicts a projectile 2000 or munition 2000 comprising the system 100 including the transducer of Figure 1 and the structure of Figures 2 and 3 or the structure 200 of Figures 2 and 3. A projectile means any object that moves freely under the influence of gravity and air resistance - e.g. it does not comprise any propulsion arrangement. Munitions are provided in different forms for different applications. Typically, a particular munition will be used for a particular application or intention. Munitions include, but are not limited to, artillery shells and charges, missiles, rockets and mortar rounds, as well as small arms munitions (e.g., bullets). Munitions typically include a charge, and optionally a fuze system for managing the detonation or explosion of that charge. Advantageously, the system 100 and structure 200, unlike batteries, can be stored for a long time without their performance being affected. Further advantageously, the system 100 and structure can be accommodated in the constrained space typically available in projectiles and munitions due to their small size. The system 100 and the structure 200 are cheap to manufacture.

In summary, the invention provides an energy harvesting system that facilitates efficient energy harvesting and which is small, stable and robust enough to be used in projectiles and munitions. In these particular applications, the energy harvesting may be advantageously used to be a power supply, or the sole power supply. Launch of a projectile and munition may cause the described transducer to generate power sufficient to perform a function, for example powering or arming a fuze system, without a separate power supply. Alternatively or additionally, launch of a projectile and munition may actually be detected using the same transducer. As described above, the embodiments might allow for more efficient power generation, or more sensitive detection, by conversion of compressive forces to distinct shear regions.

All of the features disclosed in this specification (including any accompanying claims and drawings), and/or all of the steps of any method or process so disclosed, may be combined in any combination, except combinations where at most some of such features and/or steps are mutually exclusive.

Throughout this specification, the term "comprising" or "comprises" means including the component(s) specified but not to the exclusion of the presence of other components. The term "consisting essentially of" or "consists essentially of" means including the components specified but excluding other components except for materials present as impurities, unavoidable materials present as a result of processes used to provide the components, and components added for a purpose other than achieving the technical effect of the invention, such as colourants, and the like.

The term "consisting of" or "consists of" means including the components specified but excluding other components.

Whenever appropriate, depending upon the context, the use of the term "comprises" or "comprising" may also be taken to include the meaning "consists essentially of" or "consisting essentially of", and also may also be taken to include the meaning "consists of" or "consisting of".

The optional features set out herein may be used either individually or in combination with each other where appropriate and particularly in the combinations as set out in the accompanying claims. The optional features for each aspect or exemplary embodiment of the invention, as set out herein are also applicable to all other aspects or exemplary embodiments of the invention, where appropriate. In other words, the skilled person reading this specification should consider the optional features for each aspect or exemplary embodiment of the invention as interchangeable and combinable between different aspects and exemplary embodiments. The invention is defined by the appended claims.

## Claims

1. An energy harvesting system, comprising:
a transducer (100) arranged to provide an output signal in response to deformation of the transducer by an applied force to harvest energy from the applied force;
a structure (200) in mechanical communication with the transducer and extending across the transducer, deformation of the structure being arranged to cause deformation of the transducer,
wherein the mechanical communication is at a number of distinct points (210), and
wherein portions of the structure are angled away from being perpendicular to the transducer, whereby a compressive force applied to the structure and transducer is redirected to a shear force on the transducer at the points,
wherein a perimeter (101) of the structure and/or transducer is circular, **characterized in that** the structure is configured to redirect the shear force in circumferential direction.

2. The system of claim 1, wherein the portions of the structure which are at adjacent points are angled away from each other.

3. The system of any preceding claim, wherein the shear force is directed toward/away from adjacent points.

4. The system of any preceding claim, wherein adjacent points are equally distributed.

5. The system of any preceding claim, wherein the structure has a wave-like profile.

6. The system of any preceding claim, wherein the structure and/or transducer has an annular cross-section.

7. The system of any preceding claim, wherein the transducer is piezoelectric or magnetostrictive.

8. The system of any preceding claim, wherein the transducer is more efficient under shear force than under compression in terms of providing an output signal in response to deformation of the transducer by an applied force.

9. The system of any preceding claim, further comprising an electrode arrangement, wherein the configuration of the electrode arrangement is arranged to map onto the points.

10. The system of any preceding claim, wherein the output signal is used for powering an external component and/or detecting a change in state in the energy harvesting system.

11. A projectile (2000) comprising the system of any preceding claim.

12. A munition (2000) comprising the system of any of claims 1 to 10.

## Patentansprüche

1. Energiegewinnungssystem, umfassend:
einen Wandler (100), der angeordnet ist, um ein Ausgangssignal als Reaktion auf eine Verformung des Wandlers durch eine aufgebrachte Kraft bereitzustellen, um Energie aus der aufgebrachten Kraft zu gewinnen;
eine Struktur (200) in mechanischer Verbindung mit dem Wandler und die sich über den Wandler erstreckt, wobei die Verformung der Struktur ausgelegt ist, um die Verformung des Wandlers zu bewirken,
wobei die mechanische Verbindung an einer Anzahl von eindeutigen Punkten (210) erfolgt und
wobei Abschnitte der Struktur abgewinkelt sind, sodass sie nicht senkrecht zu dem Wandler sind, wodurch eine Druckkraft, die auf die Struktur und den Wandler aufgebracht wird, zu einer Scherkraft auf den Wandler an den Punkten umgeleitet wird,
wobei ein Umfang (101) der Struktur und/oder des Wandlers kreisförmig ist, **dadurch gekennzeichnet, dass**
die Struktur konfiguriert ist, um die Scherkraft in einer Umfangsrichtung umzuleiten.

2. System nach Anspruch 1, wobei die Abschnitte der Struktur, die sich an angrenzenden Punkten befinden, voneinander abgewinkelt sind.

3. System nach einem der vorstehenden Ansprüche, wobei die Scherkraft zu angrenzenden Punkten hin/von diesen weg gerichtet ist.

4. System nach einem der vorstehenden Ansprüche, wobei angrenzende Punkte gleichmäßig verteilt sind.

5. System nach einem der vorstehenden Ansprüche, wobei die Struktur ein wellenartiges Profil aufweist.

6. System nach einem der vorstehenden Ansprüche, wobei die Struktur und/oder der Wandler einen ringförmigen Querschnitt aufweist.

7. System nach einem der vorstehenden Ansprüche, wobei der Wandler piezoelektrisch oder magnetostriktiv ist.

8. System nach einem der vorstehenden Ansprüche, wobei der Wandler unter Scherkraft effizienter als unter Kompression in Bezug auf das Bereitstellen eines Ausgangssignals als Reaktion auf die Verformung des Wandlers durch eine aufgebrachte Kraft ist.

9. System nach einem der vorstehenden Ansprüche, ferner umfassend eine Elektrodenanordnung, wobei die Konfiguration der Elektrodenanordnung ausgelegt ist, um auf die Punkte zu kartieren.

10. System nach einem der vorstehenden Ansprüche, wobei das Ausgangssignal zum Versorgen einer externen Komponente mit Energie und/oder zum Erkennen einer Zustandsänderung in dem Energiegewinnungssystem verwendet wird.

11. Projektil (2000), umfassend das System nach einem der vorstehenden Ansprüche.

12. Munition (2000), umfassend das System nach einem der Ansprüche 1 bis 10.

## Revendications

1. Système de récupération d'énergie, comprenant :
un transducteur (100) agencé pour fournir un signal de sortie en réponse à une déformation du transducteur par une force appliquée pour récupérer de l'énergie provenant de la force appliquée ;
une structure (200) en communication mécanique avec le transducteur et s'étendant à travers le transducteur, une déformation de la structure étant agencée pour amener une déformation du transducteur,
dans lequel la communication mécanique est au niveau d'un certain nombre de points distincts (210), et
dans lequel des parties de la structure forment un angle à l'écart d'une perpendicularité par rapport au transducteur, moyennant quoi une force de compression appliquée à la structure et au transducteur est redirigée vers une force de cisaillement sur le transducteur au niveau des points,
dans lequel un périmètre (101) de la structure et/ou du transducteur est circulaire, **caractérisé en ce que**
la structure est conçue pour rediriger la force de cisaillement dans une direction circonférentielle

2. Système selon la revendication 1, dans lequel les parties de la structure qui sont au niveau de points adjacents forment un angle à l'écart les unes des autres.

3. Système selon l'une quelconque revendication précédente, dans lequel la force de cisaillement est dirigée en direction/à l'écart de points adjacents.

4. Système selon l'une quelconque revendication précédente, dans lequel les points adjacents sont répartis de manière égale.

5. Système selon l'une quelconque revendication précédente, dans lequel la structure a un profil de type ondulé.

6. Système selon l'une quelconque revendication précédente, dans lequel la structure et/ou le transducteur ont une section transversale annulaire.

7. Système selon l'une quelconque revendication précédente, dans lequel le transducteur est piézoélectrique ou magnétostrictif.

8. Système selon l'une quelconque revendication précédente, dans lequel le transducteur est plus efficace sous une force de cisaillement que sous compression en termes de fourniture d'un signal de sortie en réponse à une déformation du transducteur par une force appliquée.

9. Système selon l'une quelconque revendication précédente, comprenant en outre un agencement d'électrodes, dans lequel la configuration de l'agencement d'électrodes est agencée pour correspondre aux points.

10. Système selon l'une quelconque revendication précédente, dans lequel le signal de sortie est utilisé pour alimenter en puissance un composant externe et/ou pour détecter un changement d'état dans le système de récupération d'énergie.

11. Projectile (2000) comprenant le système selon l'une quelconque revendication précédente.

12. Munition (2000) comprenant le système selon l'une quelconque des revendications 1 à 10.
